# EUROPÄISCHE PATENTSCHRIFT

(11) **EP 0 659 287 B1**
(45) Veröffentlichungstag und Bekanntmachung des Hinweises auf die Patenterteilung: **30.10.1996**
(21) Anmeldenummer: 93919133.4
(22) Anmeldetag: 21.08.1993
(51) Int. Cl.: G03G 13/26, G03G 13/32, G03G 7/00, G03F 1/00

(54) **VERFAHREN ZUM ÜBERTRAGEN EINES BILDMUSTERS**
IMAGE-TRANSFER PROCESS
PROCEDE POUR LE TRANSFERT D'UN ECHANTILLON D'IMAGE

(30) Priorität: 09.09.1992 DE 4230142
(43) Veröffentlichungstag der Anmeldung: 28.06.1995
(73) Patentinhaber: LIEBETRUTH, Kai, D-50733 Köln (DE)
(72) Erfinder: LIEBETRUTH, Kai, D-50733 Köln (DE)
(74) Vertreter: Selting, Günther, Dipl.-Ing.
(86) Internationale Anmeldenummer: EP9302249
(87) Internationale Veröffentlichungsnummer: WO9406060

(56) Entgegenhaltungen:
- DE-B- 1 025 719
- DE-C- 3 924 848
- GB-A- 356 850
- NL-A- 6 906 325
- US-A- 2 949 848
- US-A- 3 999 481
- US-A- 4 226 930
- PATENT ABSTRACTS OF JAPAN vol. 6, no. 121 (P-126)(999) 6. Juli 1982 & JP,A,57 046 242 (FUJI KAGAKU SHIKOUGIYOU K.K.) 16. März 1982

## Beschreibung

Die Erfindung betrifft ein Verfahren zum Übertragen eines auf einem Vorlagenmaterial enthaltenen Bildmusters auf ein Kopiermaterial.

Es ist bekannt, negative Kopiervorlagen zum Belichten von lichtempfindlichen Materialien auf photographischem Wege zu erzeugen, indem ein Negativfilm hergestellt wird. Das auf dem Negativfilm enthaltene Negativ stellt das tonwertvertauschte Bild der Vorlage dar. Solche negativen Kopiervorlagen werden beispielsweise für die Stempelherstellung, für die Herstellung von Druckklischees oder für Siebdruckverfahren benutzt. Die Herstellung der Kopiervorlagen auf fotografischem Wege erfordert eine umfangreiche Ausrüstung und einen relativ hohen apparativen Aufwand. Für private Nutzer kommt somit die Herstellung negativer Kopiervorlagen in der Regel nicht in Betracht.

Aus DE-C-39 24 848 ist ein Verfahren zum Übertragen eines Bildmusters bekannt, bei dem ein Tonerbild zunächst auf Wachspapier übertragen wird. Von dem Wachspapier wird das Tonerbild anschließend komplett abgelöst und auf eine Übertragungsfolie übertragen, so daß der Toner die Übertragungsfolie überlagert und an dieser haftet. Anschließend wird das Tonerbild zusammen mit Teilen der Übertragungsfolie auf ein Klebeband oder ein ähnliches Substrat übertragen. Dabei wird kein negatives Durchsichtbild hergestellt. Es wird auch nicht die Eigenschaft des Toners ausgenutzt, an dem Vorlagenmaterial zu haften und gleichzeitig die Fähigkeit zu besitzen, sich unter Druck und Wärme mit der Übertragungsschicht einer Übertragungsfolie zu verbinden und diese somit am Vorlagenmaterial festzuhalten.

Bekannt sind ferner Transfermaterialien, die im Kontaktverfahren die farbige Beschichtung einer Fotokopie ermöglichen (EP 0 191 592, DE 4 110 801 C 1).

Eine solche Übertragungs- oder Transferfolie enthält auf einer transparenten Trägerschicht eine übertragungsschicht, die aus einer Metall- oder Pigmentschicht und einer Harzschicht besteht. Wird die Harzschicht mit dem Tonermaterial einer Fotokopie in Kontakt gebracht, so verbindet sie sich unter Druck und Wärme mit dem Tonermaterial. Beim Abziehen der Trägerschicht verbleibt die Übertragungsschicht an der Fotokopie, wobei die mit Toner versehenen Schichten der Fotokopie dann die Metallschicht tragen. Auf diese Weise ist es möglich, eine Fotokopie derart optisch zu verändern, daß anstelle der geschwärzten Stellen anders farbige Stellen zu sehen sind. Eine derartige Übertragungsfolie ist jedoch nicht dazu bestimmt, von einer Vorlage eine Kopie herzustellen.

Der Erfindung liegt die Aufgabe zugrunde, ein Verfahren zum Übertragen eines auf einem Vorlagenmaterial enthaltenen Bildmusters auf ein Kopiermaterial anzugeben, das mit geringem Aufwand durchführbar ist und ohne Verwendung aufwendiger Apparaturen ausgeführt werden kann.

Die Lösung dieser Aufgabe erfolgt erfindungsgemäß mit den im Patentanspruch 1 angegebenen Merkmalen.

Bei dem erfindungsgemäßen Verfahren wird das Durchsichtbild, durch das hindurch die Reaktionsschicht des Kopiermaterials belichtet wird, mit einer Übertragungsfolie erzeugt, die im Kontaktverfahren mit einer Fotokopie mit einem Negativ-Muster der Fotokopie versehen worden ist. Dabei wird, wie bei Folien zum Einfärben von Fotokopien üblich, die Fotokopie an ihren geschwärzten Stellen mit der Übertragungsschicht der Übertragungsfolie beschichtet, jedoch wird der verbleibende Teil der Übertragungsfolie, nämlich die Trägerfolie mit dem in der Übertragungsschicht enthaltenen Negativbild, für die nachfolgende fotografische Herstellung des Bildmusters benutzt. Während bei einer Übertragungsfolie normalerweise nur die auf die Fotokopie übertragenen Bereiche der Übertragungsschicht ausgenutzt und der verbleibende Teil der Übertragungsfolie fortgeworfen wird, wird bei dem erfindungsgemäßen Verfahren der nach der Übertragung verbleibende Teil der Übertragungsfolie fototechnisch weiterbenutzt, um damit ein Reliefbild zu erzeugen. Die Herstellung des Durchsichtbildes erfolgt erfindungsgemäß nicht auf fotografischem Wege, sondern durch Kontaktübertragung mit Druck und Wärme.

Das erfindungsgemäße Verfahren erlaubt es, auch Privatpersonen, Schulkinder, Heimwerker o.dgl. in die Lage zu versetzten, mit einem einfachen Materialsatz von einem grafischen Positiv Stempel oder andere Reliefreproduktionen oder Flächenmuster herzustellen. Das Verfahren kann auch für die Herstellung von Leiterplatten im Fotoätzverfahren eingesetzt werden. Benötigt werden lediglich die Übertragungsfolie und das die fotoempfindliche Reaktionsschicht enthaltende Material. Besondere Apparate sind nicht erforderlich. Für die Herstellung des Durchsichtbildes mit der übertragungsfolie genügt ein Bügeleisen, mit dem Druck und Wärme ausgeübt werden können. Das Härten der Reaktionsschicht kann mit UV-haltigem Tageslicht erfolgen.

Das erfindungsgemäße Verfahren eignet sich darüber hinaus auch zur Herstellung eines mit einem Bildmuster versehenen Kopiermaterials, dessen Bild auf ein anderes Substrat übertragen wird, z.B. auf ein Textilmaterial. Schließlich kann das Verfahren auch dazu benutzt werden, ein für das Siebdruckverfahren benutzbares Tuch an selektiven Stellen farbdurchlässig zu machen.

Im folgenden werden unter Bezugnahme auf die Zeichnungen Ausführungsbeispiele der Erfindung näher erläutert.

Es zeigen:
- Fig. 1: eine Ansicht eines ein Bildmuster tragenden Vorlagenmaterials,
- Fig. 2: in einem Schnitt entlang der Linie II-II von Fig. 1 die Übertragung des Bildmusters auf eine Übertragungsfolie,
- Fig. 3: eine Ansicht der das Negativ des Bildmusters tragenden Übertragungsfolie,
- Fig. 4: die Belichtung eines Kopiermaterials durch die Übertragungsfolie hindurch,
- Fig. 5: ein Schnitt durch das Kopiermaterial mit den erhabenen Bildmusterstellen,
- Fig. 6: eine perspektivische Darstellung des mit dem erhabenen Bildmuster versehenen Kopiermaterials das als Stempel benutzbar ist,
- Fig. 7: bei einer anderen Form der Ausführungsform des Verfahrens das Belichten eines Kopiermaterials durch die das Negativ-Muster tragende Übertragungsfolie hindurch,
- Fig. 8: die Übertragung des nach Fig. 7 auf dem kopiermaterialerzeugten Bildes auf ein Substrat,
- Fig. 9: das Ablösen des Kopiermaterials von dem Substrat, so daß das Bild an dem Substrat haften bleibt,
- Fig. 10: die Verwendung eines nach Fig. 7 hergestellten Kopiermaterials zum selektiven Belichten eines für ein nachfolgendes Siebdruckverfahren zu verwendenen Substrats und
- Fig. 11: die Benutzung des nach Fig. 10 hergestellten Substrats für ein Siebdruckverfahren.

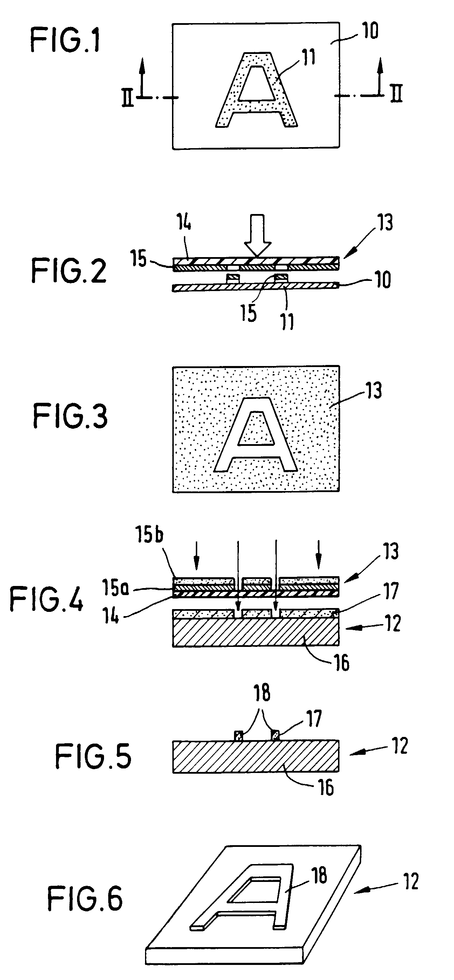

Fig. 1 zeigt ein Vorlagenmaterial 10, das aus einem Blatt Papier besteht, auf dem durch ein Fotokopierverfahren ein Bildmuster 11 aus geschmolzenem und gehärteten Tonermaterial erzeugt worden ist. Von diesem Bildmuster 11 soll auf einem Kopiermaterial 12 ein positives Reliefbild erzeugt werden, das gemäß Fig. 6 als Stempel benutzt werden kann.

Das Vorlagenmaterial 10 wird entsprechend Fig. 2 mit einer Übertragungsfolie 13 bedeckt, die eine transparente Trägerschicht 14 und eine Übertragungsschicht 15 aufweist. Die Übertragungsschicht 15 besteht aus einer Metallschicht 15a und einer die Metallschicht 15a bedeckenden Harzschicht 15b. Wenn die Harzschicht 15b in fester Anlage an dem Vorlagenmaterial 10 liegt, verbindet sich bei Anwendung von Druck und Temperatur, indem, beispielsweise mit einem Bügeleisen, die Übertragungsfolie 13 gegen das Vorlagenmaterial 10 gedrückt wird, die Harzschicht 15b mit der aufschmelzenden Tonerschicht, die das Bildmuster 11 bildet. An den übrigen Stellen verbindet sich die Übertragungsfolie 13 nicht mit dem Vorlagenmaterial 10. Wird die übertragungsfolie 13 anschließend von dem Vorlagenmaterial 10 abgenommen, dann verbleibt die Übertragungsschicht 15 nur an den Toner aufweisenden Stellen des Bildmusters 11 am Vorlagenmaterial. An allen übrigen Stellen löst sich die an der Trägerfolie 14 haftende Übertragungsschicht 15 von dem Vorlagenmaterial. Dadurch entsteht das in Fig. 3 dargestellte negative Durchsichtbild der Übertragungsfolie 13, bei dem die Übertragungsschicht 15 im Bereich des Bildmusters fehlt. Die Übertragungsfolie 13 gemäß Fig. 3 bildet also ein Negativ des Vorlagenmaterials 10.

Diese Übertragungsfolie 13 wird gemäß Fig. 4 seitenverkehrt, d.h. mit der Trägerschicht nach unten, auf das Kopiermaterial 12 aufgelegt. Das Kopiermaterial 12 besteht aus einem Trägermaterial 16, das mit einer fotoempfindlichen Reaktionsschicht 17 aus einem Fotopolymer beschichtet ist. Auf diese Reaktionsschicht 17 wird die Übertragungsfolie 13 gelegt und mit aktinischer Strahlung belichtet. An denjenigen Stellen, an denen die Übertragungsfolie 13 transparent ist, wird die Reaktionsschicht belichtet und an denjenigen Stellen, an denen die Metallschicht 15a erhalten ist, wird die Reaktionsschicht 17 nicht belichtet. Die Belichtung erfolgt im Kontaktverfahren beispielsweise bei Tageslicht über wenige Minuten. An den belichteten Stellen härtet die Reaktionsschicht 17 aus und an den unbelichteten Stellen bleibt sie löslich, so daß sie durch Spülen mit Wasser entfernt werden können.

Fig. 5 zeigt das Kopiermaterial 12, bei dem nur die durch Licht gehärteten Stellen 18 der Reaktionsschicht 17 erhalten und die übrigen Teile der Reaktionsschicht fortgewaschen sind. Die gehärteten Stellen 18 stellen gemäß Fig. 6 eine positive Reliefstruktur des auf dem Vorlagenmaterial 10 gemäß Fig. 1 enthaltenen Bildmusters 11 dar. Die Struktur nach Fig. 6, d.h. das Kopiermaterial 12 mit dem erhabenen Reliefmuster, kann als Stempel benutzt werden, z.B. als Namenstempel, Firmenstempel oder Motivstempel.

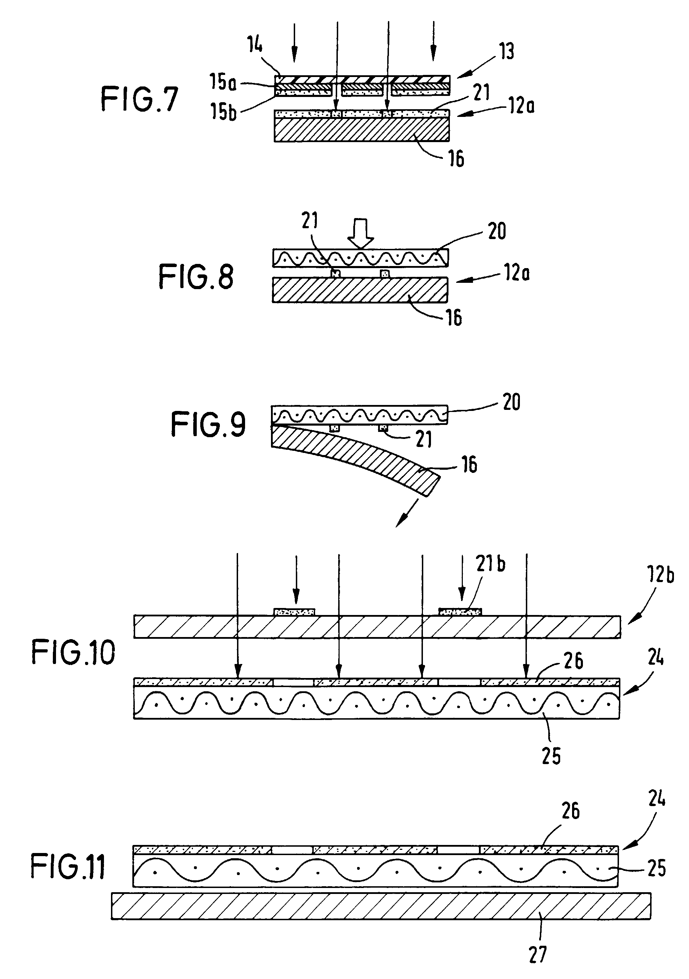

Auch bei dem Ausführungsbeispiel der Fign. 7-9 wird mit der Übertragungsfolie 13 in gleicher Weise ein Negativbild hergestellt, wie dies an Hand der Fign. 1-3 erläutert wurde. Das Ausführungsbeispiel der Fign. 7-9 zeigt, wie mit Hilfe der das Negativbild tragenden Übertragungsfolie die Bedruckung eines Substrats 20 erfolgen kann, bei dem es sich beispielsweise um ein Textilmaterial handelt.

Zunächst wird gemäß Fig. 7 die Übertragungsfolie 13 dazu benutzt, seitenrichtig, d.h. mit nach oben gerichteter Trägerfolie 14, ein Kopiermaterial 12a selektiv zu belichten. Dieses Kopiermaterial 12a besteht aus einem Träger 16 aus Papier oder Folie, der mit einer Reaktionsschicht 21 beschichtet ist. Diese Reaktionsschicht 21 enthält einerseits einen Fotopolymer, so daß sie bei Lichteinfall härtet, und andererseits einen Schmelzklebstoff, der sich unter Druck und Wärme mit anderem Material verbinden kann. Die Reaktionsschicht 21 wird durch die Übertragungsfolie 13 hindurch selektiv belichtet, um an den belichteten Stellen zu härten. Die ungehärteten Bereiche werden anschließend mit einem Lösungsmittel ausgewaschen.

Dann wird gemäß Fig. 8 das Kopiermaterial 12a mit einem Substrat 20 bedeckt, das beispielsweise aus Textilmaterial betehen kann und das mit einem Bügeleisen gegen das Kopiermaterial 12a gedrückt wird. Dabei verbinden sich unter Druck und Wärme die gehärteten Reste der Reaktionsschicht 21 mit dem Substrat 20, an dem sie haften bleiben, wenn das Trägermaterial 16 abgezogen wird.

Auf die beschriebene Weise wird das auf dem Vorlagenmaterial 10 befindliche Bildmuster 11 mit Hilfe der Übertragungsfolie 13 und des Kopiermaterials 12a auf das Substrat 20 übertragen. Das Verfahren eignet sich dazu, Muster, die auf Fotokopien enthalten sind, beispielsweise auf T-Shirts zu übertragen. Man benötigt hierzu lediglich die Übertragungsfolie, das Kopiermaterial sowie ein Bügeleisen.

Die Figuren 10 und 11 zeigen die Herstellung eines aus Textilmaterial bestehenden Siebes 24, das für das Siebdruckverfahren geeignet ist. Zunächst wird, wie oben anhand der Fig. 7 erläutert wurde, auf einem Kopiermaterial 12b ein Positiv-Muster aus den gehärteten Resten der Reaktionsschicht 21 hergestellt. Der Träger des Kopiermaterials 12b kann aus einem beliebigen starren oder flexiblen Material bestehen. Durch das lichtdurchlässige Kopiermaterial 12b hindurch wird das Sieb 24 belichtet, wobei das Licht von den Resten der Reaktionsschicht 21 nicht durchgelassen wird. Das Sieb 24 weist in üblicher Weise eine Gazeschicht 25 auf. Diese Gazeschicht 25 ist an einer Seite mit einer lichtempfindlichen Reaktionsschicht 26 beschichtet. Bei Belichtung durch das Kopiermaterial 12b hindurch werden diejenigen Stellen der Reaktionsschicht 26, die unter den gehärteten Stellen 21b des Kopiermaterials 12b liegen, nicht mit Licht beaufschlagt. Diese Stellen werden somit nicht gehärtet und sie können anschließend mit Wasser oder mit einem anderen Lösungsmittel ausgewaschen werden. Es verbleiben dann nur die gehärteten Bereiche der Reaktionsschicht 26, die ein Negativ des Bildmusters 11 auf dem Vorlagenmaterial 10 darstellen. An den Stellen der gehärteten Reaktionsschicht 26 ist das Sieb 24 undurchlässig für Farbe.

Gemäß Fig. 11 wird das Sieb 24 auf ein Blatt Papier 27 gelegt. Dann wird Farbe auf das Sieb 24 aufgetragen und mit einer Rakel glattgestrichen. Die Farbe gelangt dann nur durch die Öffnungen der Schicht 26 auf das Papier 27. Anstelle von Papier 27 kann auch beispielsweise Textilmaterial bedruckt werden.

Die Herstellung des Siebes 24 kann auch in der Weise erfolgen, daß von einer Fotokopie mit der Übertragungsfolie ein negatives Durchsichtbild erstellt wird, welches anschließend mit einem Fotokopierer kopiert wird, um eine negative Papierkopie zu erhalten. Von dieser wird mit einer Übertragungsfolie ein positives Übertragungsbild erzeugt, durch das die lichtempfindliche Schicht des Siebes belichtet wird.

Es ist auch möglich, von einer positiven Bildvorlage eine Kopie auf einer durchsichtigen Overheadfolie zu erzeugen. Diese wird mit der Übertragungsfolie beschichtet und dann für die Belichtung der lichtempfindlichen Schicht des Siebes benutzt. Durch die Beschichtung der Tonerschicht mit einer Übertragungsschicht wird das Lichtrückhaltevermögen verbessert, so daß eine exakte Belichtung möglich ist.

## Patentansprüche

1. Verfahren zum Übertragen eines auf einem Vorlagenmaterial (10) enthaltenen Bildmusters auf ein Kopiermaterial (12,12a,12b), bei welchem ein dem Bildmuster des Vorlagenmaterials (10) entsprechendes negatives Durchsichtbild hergestellt und durch dieses hindurch eine fotoempfindliche Reaktionsschicht (17,21) belichtet wird, die anschließend durch Entfernen von Material der unbelichteten Schichtstellen weiterbehandelt wird,
**dadurch gekennzeichnet**,
daß das Durchsichtbild mit einer übertragungsfolie (13) erzeugt wird, die auf das als Fotokopie vorliegende Vorlagenmaterial (10) aufgelegt wird, wobei sich die mit Toner versehenen Stellen des Vorlagenmaterials (10) durch Druck und Wärme mit einer lichtrückhaltenden Übertragungsschicht (15a) der Übertragungsfolie (13) verbinden und diese von einem transparenten Trägermaterial (14) der Übertragungsfolie ablösen.

2. Verfahren nach Anspruch 1, dadurch gekennzeichnet, daß das Kopiermaterial (12a,12b) einen mit einer Reaktionsschicht (21) beschichteten Träger (16) aufweist, daß die Reaktionsschicht (21) einen Heißschmelzkleber enthält oder damit beschichtet ist und daß die nach dem Belichten der ReaktionsSchicht (21) und dem Entfernen von Material von den unbelichteten Stellen stehengebliebenen Teile der Reaktionsschicht durch Druck und Wärme auf ein Substrat (20) übertragen werden.

3. Verfahren nach Anspruch 2, dadurch gekennzeichnet, daß das Substrat (20) ein Textilmaterial ist.

4. Verfahren nach Anspruch 1, dadurch gekennzeichnet, daß das Kopiermaterial (12b) zum Belichten einer fotoempfindlichen Reaktionsschicht (26) eines Siebes (24) benutzt wird, wodurch das Sieb (24) an selektiven Stellen für Farbe undurchlässig wird, und daß das Sieb (27) im Siebdruckverfahren benutzt wird.

5. Verfahren zum Übertragen eines auf einem Vorlagenmaterial enthaltenen Bildmusters auf ein Kopiermaterial mit den folgenden Schritten:
a) Herstellen eines dem Bildmuster des Vorlagenmaterials entsprechenden Durchsichtbildes durch Fotokopieren auf ein durchsichtiges Material,
b) Verbinden der Tonerstellen des durchsichtigen Materials mit der Übertragungsschicht einer Übertragungsfolie durch Druck und Wärme,
c) Belichten einer fotoempfindlichen Reaktionsschicht durch das Durchsichtbild hindurch,
d) Weiterbehandeln der fotoempfindlichen Reaktionsschicht durch Entfernen von Material der unbelichteten Schichtstellen.

## Claims

1. A method for transfer of an image pattern formed on a master material (10) onto a copying material (12,12a,12b), wherein a negative transparent image corresponding to the image pattern of the master material (10) is produced and is used for exposing therethrough a photosensitive reaction layer (17,21) which then is further processed by removing material of the non-exposed regions of said layer,
**characterized in**
that the transparent image is generated by means of a transfer film (13) which is laid over the master material (10) provided as a photocopy, wherein those regions of the master material (10) which have toner arranged thereon become attached by pressure and heat to a light-retaining transfer layer (15a) of the transfer film (13) and remove the light-retaining transfer layer (15a) from a transparent carrier material (14) of the transfer film.

2. The method according to claim 1, characterized in that the copying material (12a,12b) comprises a carrier (16) coated with a reaction layer (21), that the reaction layer (21) includes a hot-melt adhesive or is coated therewith, and that those regions of the reaction layer which remain after exposure of the reaction layer (21) and removal of material from the non-exposed regions, are transferred by pressure and heat onto a substrate (20).

3. The method according to claim 2, characterized in that the substrate (20) is a textile material.

4. The method according to claim 1, characterized in that the copying material (12b) is used for exposure of a photosensitive reaction layer (26) of a screen (24) to render the screen (24) impermeable to colorants in selective regions, and that the screen (24) is used in a screen printing process.

5. A method for transfer of an image pattern formed on a master material onto a copying material, comprising the following steps:
a) by photocopying onto a transparent material, producing a transparent image corresponding to the image pattern of the master material,
b) attaching the toner regions of the transparent material by pressure and heat to the transfer layer of a transfer film,
c) exposing a photosensitive reaction layer through the transparent image,
d) further processing the photosensitive reaction layer by removing material of the non-exposed regions of said layer.

## Revendications

1. Procédé pour le transfert d'un échantillon d'image, qui fait partie d'un matériau formant l'original (10), sur un matériau pour copie (12, 12a, 12b), selon lequel on produit une image transparente négative correspondant à l'échantillon d'image de l'original (10) et on expose à la lumière, à travers cette image transparente, une couche réactive (17, 21) photosensible qui est ensuite traitée par enlèvement de matière aux endroits non exposés de la couche,
caractérisé en ce que,
l'on produit l'image transparente avec une feuille de transfert (13) qui est posée sur l'original (10) présent comme photocopie, les endroits de l'original (10) qui sont couverts de toner se liant par pression et chaleur à une couche de transfert (15a), qui retient la lumière, de la feuille de transfert (13), et détachant cette couche de transfert d'un matériau transparent formant support (14) qui fait partie de la feuille de transfert.

2. Procédé selon la revendication 1, caractérisé en ce que le matériau pour copie (12a, 12b) comporte un support (16) recouvert d'une couche réactive (21), en ce que la couche réactive (21) contient une colle fusible à chaud ou en est recouverte et en ce que les parties de la couche réactive qui restent après l'exposition à la lumière de la couche réactive (21) et après l'élimination du matériau des endroits non exposés sont transférées par pression et chaleur sur un substrat (20).

3. Procédé selon la revendication 2, caractérisé en ce que le substrat (20) est une matière textile.

4. Procédé selon la revendication 1, caractérisé en ce que le matériau pour copie (12b) est utilisé pour l'exposition à la lumière d'une couche réactive photosensible (26) d'un écran (24), ce qui rend l'écran (24) opaque à la couleur en des endroits sélectifs, et en ce que l'écran (24) est utilisé en sérigraphie.

5. Procédé pour le transfert d'un échantillon d'image, qui fait partie d'un matériau formant l'original, sur un matériau pour copie, comportant les opérations suivantes :
a) production d'une image transparente, correspondant à l'échantillon d'image de l'original, par photocopie sur un matériau transparent,
b) liaison, par pression et chaleur, des endroits du matériau transparent qui sont couverts de toner avec la couche de transfert d'une feuille de transfert,
c) exposition à la lumière, à travers l'image transparente, d'une couche réactive photosensible,
d) traitement ultérieur de la couche réactive photosensible par élimination de la matière aux endroits non exposés de la couche.
